# EUROPEAN PATENT APPLICATION

(11) **EP 3 561 861 A1**
(43) Date of publication of application: **30.10.2019**
(21) Application number: 19170077.2
(22) Date of filing: 18.04.2019
(51) Int. Cl.: H01L 21/67

(54) **SUBSTRATE PROCESSING APPARATUS AND PROGRAM FOR SUBSTRATE PROCESSING APPARATUS**

(30) Priority: 27.04.2018 JP 2018086889
(71) Applicant: Horiba Stec, Co., Ltd., Kyoto-shi, Kyoto 601-8116 (JP)
(72) Inventor: HAYASHI, Daisuke, Kyoto-shi, Kyoto 601-8116 (JP); MINAMI, Masakazu, Kyoto-shi, Kyoto 601-8116 (JP)
(74) Representative: Müller-Boré & Partner Patentanwälte PartG mbB

(57) **Abstract**

In order to make it possible to uniform a two-dimensional concentration distribution or two-dimensional temperature distribution in a chamber at high speed and with high accuracy without relying on operator's experience, the present invention is adapted to include: a chamber 10 that contains substrates and is also supplied with material gas; a laser emitting mechanism 20 that emits laser beams from multiple points around the chamber 10 toward incident windows W1 formed in the peripheral wall of the chamber 10; a laser detecting mechanism 30 that detects respective laser beams emitted from the multiple points, passing through the chamber 10, and emitted through emission windows W2 formed in the peripheral wall of the chamber 10; and a control device 40 that acquires beam intensity signals of the respective laser beams detected by the laser detecting mechanism 30, as well as on the basis of the beam intensity signals, calculates the two-dimensional concentration distribution or two-dimensional temperature distribution of the material gas in the chamber, and on the basis of the two-dimensional concentration distribution or the two-dimensional temperature distribution, controls fluid control devices MFCl.

## Description

### Technical Field

The present invention relates to a substrate processing apparatus used in a semiconductor manufacturing process and a program for the substrate processing apparatus.

### Background Art

As this sort of substrate processing apparatus, as disclosed in Patent Literature 1, there is one that performs substrate processing such as etching or deposition by supplying material gas into a chamber containing substrates, as well as heating the substrates by a heater and generating plasma in the chamber.

In such a substrate processing apparatus, if the concentration distribution (hereinafter referred to as the two-dimensional concentration distribution) of the material gas in a plane along the substrates in the chamber or the temperature distribution (hereinafter referred to as the two-dimensional temperature distribution) of the material gas in the plane is non-uniform, the above-described substrate processing is also non-uniform, and therefore, for example, the surface quality or the like of the substrates cannot be ensured.

However, in such a conventional apparatus, the two-dimensional concentration distribution or two-dimensional temperature distribution in the chamber has not been grasped, and in order to uniform the substrate processing, an operator has had to empirically adjust a supply amount from each point, or with heaters provided in multiple locations, empirically adjust heating temperature by each heater, thus taking a lot of effort and time.

### Citation List

### Patent Literatures

Patent Literature 1: Japanese Unexamined Patent Application Publication No. 2012-204692

### Summary of Invention

### Technical Problem

Therefore, the present invention has been made in order to solve the above-described problem, and a main object thereof is to make it possible to uniform a two-dimensional concentration distribution or a two-dimensional temperature distribution in a chamber at high speed and with high accuracy.

### Solution to Problem

That is, a substrate processing apparatus according to the present invention is one including: a chamber that contains a substrate and is also supplied with material gas; material gas supply paths respectively connected to multiple supply ports formed in the chamber; fluid control devices provided in the respective material gas supply paths; a laser emitting mechanism that emits laser beams from multiple points around the chamber toward an incident window formed in the peripheral wall of the chamber; a laser detecting mechanism that detects respective laser beams emitted from the multiple points, passing through the chamber, and emitted through an emission window formed in the peripheral wall of the chamber; and a control device that acquires beam intensity signals of the respective laser beams detected by the laser detecting mechanism, as well as on the basis of the beam intensity signals, calculates a two-dimensional concentration distribution of the material gas in the chamber, and on the basis of the two-dimensional concentration distribution, controls the fluid control devices.

In such a substrate processing apparatus, since the control device calculates the two dimensional concentration distribution of the material gas in the chamber on the basis of the beam intensity signals of the respective laser beams emitted from the multiple points around the chamber and passing through the chamber, and on the basis of the two-dimensional concentration distribution, controls the fluid control devices, and therefore the two-dimensional concentration distribution can be uniformed without relying on operator's experience.

It is preferable that in a configuration where multiple supply areas corresponding to the multiple supply ports are set in the chamber, and the material gas supplied to the respective supply areas is controlled by the fluid control devices in the material gas supply paths connected to the supply ports corresponding to the respective supply areas, the control device calculates, on the basis of the two-dimensional concentration distribution, area representative concentrations representing concentrations in the respective supply areas, and using the area representative concentrations, performs feedback control of the target flow rates of the fluid control devices corresponding to the respective supply areas.

Such a configuration makes it possible to control a two-dimensional concentration distribution in the chamber for each of the supply areas, and therefore the two-dimensional concentration distribution can be uniformed without complicating control.

It is preferable that the chamber includes: a chamber main body having an internal space to which the material gas is supplied; a cover body that covers the internal space and is also formed with the multiple supply ports; and a partitioning member that is provided on an internal space side of the cover body and partitions the multiple supply ports.

Such a configuration makes it possible to independently control the multiple supply areas by partitioning the multiple supply ports so that the material gas supplied from one supply port is supplied to mainly one supply area, and therefore the two-dimensional concentration distribution in the chamber can be more quickly uniformed.

The difference in two-dimensional concentration distribution is likely to occur between the central part and outer peripheral part in the chamber, and therefore in order to make it possible to respectively control concentrations in the central part and outer peripheral part of the internal space S, it is preferable that the multiple supply areas are set as an area set in the central part of the chamber, and at least one annular area surrounding the area.

This makes it easier to uniform the two-dimensional concentration distribution.

Further, a substrate processing apparatus according to the present invention is one including: a chamber that contains a substrate and is also supplied with material gas; multiple heaters for heating the inside of the chamber; a laser emitting mechanism that emits laser beams from multiple points around the chamber toward an incident window formed in the peripheral wall of the chamber; a laser detecting mechanism that detects respective laser beams emitted from the multiple points, passing through the chamber, and emitted through an emission window formed in the peripheral wall of the chamber; and a control device that acquires beam intensity signals of the respective laser beams detected by the laser detecting mechanism, as well as on the basis of the beam intensity signals, calculates a two-dimensional temperature distribution in the chamber, and on the basis of the two-dimensional temperature distribution, controls the heaters.

In such a substrate processing apparatus, the control device calculates the two-dimensional temperature distribution in the chamber on the basis of the beam intensity signals of the respective laser beams emitted from the multiple points around the chamber and passing through the chamber, and on the basis of the two-dimensional temperature distribution, controls the fluid control devices, and can therefore uniform the two-dimensional temperature distribution without relying on operator's experience.

It is preferable that multiple heating areas corresponding to the multiple heaters are set in the chamber, and the control device calculates, on the basis of the two-dimensional temperature distribution, area representative temperatures representing temperatures in the respective heating areas, and using the area representative temperatures, performs feedback control of supply powers to the respective heaters.

Such a configuration makes it possible to control a two-dimensional temperature distribution in the chamber for each of the heating areas, and can therefore uniform the two-dimensional temperature distribution without complicating control.

It is preferable to include a heat insulating partitioning member that partitions the multiple heaters.

Such a configuration makes it possible to independently control the multiple heating areas by partitioning the multiple heaters so that one heater heats mainly one heating area, and therefore the two-dimensional temperature distribution in the chamber can be more quickly uniformed.

Also, a program for a substrate processing apparatus according to the present invention is one used for a substrate processing apparatus including: a chamber that contains a substrate and is also supplied with material gas; material gas supply paths respectively connected to multiple supply ports formed in the chamber; fluid control devices provided in the respective material gas supply paths; a laser emitting mechanism that emits laser beams from multiple points around the chamber toward an incident window formed in the peripheral wall of the chamber; and a laser detecting mechanism that detects respective laser beams emitted from the multiple points, passing through the chamber, and emitted through an emission window formed in the peripheral wall of the chamber; and the program instructs a computer to fulfill a function of acquiring beam intensity signals of the respective laser beams detected by the laser detecting mechanism, as well as on the basis of the beam intensity signals, calculating a two-dimensional concentration distribution of the material gas in the chamber, and on the basis of the two-dimensional concentration distribution, controlling the fluid control devices.

Further, a program for a substrate processing apparatus according to the present invention is one used for a substrate processing apparatus including: a chamber that contains a substrate and is also supplied with material gas; multiple heaters for heating the inside of the chamber; a laser emitting mechanism that emits laser beams from multiple points around the chamber toward an incident window formed in the peripheral wall of the chamber; and a laser detecting mechanism that detects respective laser beams emitted from the multiple points, passing through the chamber, and emitted through an emission window formed in the peripheral wall of the chamber; and the program instructs a computer to fulfill a function of acquiring beam intensity signals of the respective laser beams detected by the laser detecting mechanism, as well as on the basis of the beam intensity signals, calculating a two-dimensional temperature distribution in the chamber, and on the basis of the two-dimensional temperature distribution, controlling the heaters.

These programs for the substrate processing apparatuses can produce the same working effects as those of the above-described substrate processing apparatuses

### Advantageous Effects of Invention

According to the present invention configured as described above, it is possible to uniform the two-dimensional concentration distribution and/or two-dimensional temperature distribution in the chamber at high speed and with high accuracy without relying on operator's experience.

### Brief Description of Drawings

FIG. 1 is a diagram schematically illustrating the configuration of a substrate processing apparatus in the present embodiment;
FIG. 2 is a diagram schematically illustrating the configuration of a laser emitting mechanism and a laser detecting mechanism in the same embodiment;
FIG. 3 is a cross-sectional view illustrating the configuration of a chamber in the same embodiment;
FIG. 4 is an exploded perspective view illustrating the configuration of the chamber in the same embodiment;
FIG. 5 is a cross-sectional view schematically illustrating beam paths formed in the chamber in the same embodiment;
FIG. 6 is a perspective view illustrating the configuration of a partitioning member and a heat insulating partitioning member in the same embodiment;
FIG. 7 is a functional block diagram illustrating functions of a control device in the same embodiment;
FIG. 8 is a flowchart illustrating a concentration control operation of the control device in the same embodiment;
FIG. 9 is a flowchart illustrating a temperature control operation of the control device in the same embodiment; and
FIG. 10 is a perspective view schematically illustrating the configuration of a partitioning member in another embodiment.

### Description of Embodiments

In the following, one embodiment of the substrate processing apparatus according to the present invention will be described with reference to drawings.

A substrate processing apparatus of the present embodiment is one that is used in a semiconductor manufacturing process and performs substrate processing such as deposition or etching on substrates such as wafers.

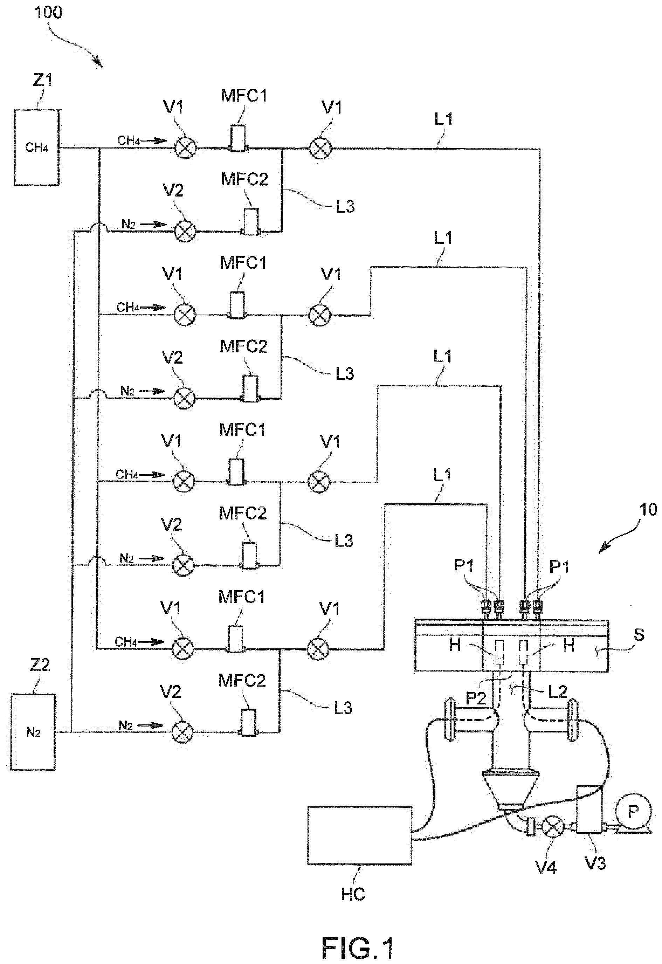

Specifically, as illustrated in FIG. 1, the substrate processing apparatus 100 includes: a chamber 10 for containing substrates (not illustrated); material gas supply paths L1 for supplying material gas such as CH₄ into the chamber 10; and a material gas exhaust path L2 for exhausting the material gas supplied into the chamber 10. In addition, the material gas is not limited to CH₄ but may be appropriately changed to SiF₄, CFₓ, or the like.

The chamber 10 is one formed with an internal space S for containing substrates, and the internal space S is provided with heaters H for heating the substrates. In addition, the above-described substrate processing is performed by generating plasma in the internal space S of the chamber 10 and heating the internal space S to high temperature while heating the substrates by the heaters H as well as supplying the material gas into the chamber 10.

The chamber 10 is formed with: multiple supply ports P1 for supplying the material gas; and an exhaust port P2 for exhausting the material gas supplied to the internal space S.

One ends of the material gas supply paths L1 are connected to the above-described supply ports P1, and the other ends are connected to a gas source Z1 of the material gas. Note that the multiple supply ports P1 are respectively connected with the material gas supply paths L1, and the multiple material gas supply paths L1 are provided mutually parallel. This makes it possible to independently control the flow rate or the like of the material gas flowing through each of the material gas supply paths L1.

Each of the material gas supply paths L1 is provided with one or more on-off valves V1 and a first fluid control device MFC1 for controlling the physical quantity of the material gas, such as a flow rate or pressure. The first fluid control device MFC1 here is a differential pressure type or thermal type mass flow controller for controlling the flow rate of the material gas flowing through the material gas supply path L1, and calculates an actual flow rate through the material gas supply path L1 to control a fluid control valve (not illustrated) so that the actual flow rate comes close to a preliminarily inputted target flow rate.

Also, the respective material gas supply paths L1 are connected with diluent gas supply paths L3 through which diluent gas for diluting the material gas, such as nitrogen gas, flows, and these multiple diluent gas supply paths L3 are provided mutually parallel. This makes it possible to independently control the flow rate or the like of the diluent gas flowing through each of the diluent gas supply paths L3.

One ends of the respective diluent gas supply paths L3 are connected to the material gas supply paths L1, and the other ends are connected to a gas source Z2 of the diluent gas. In addition, each of the diluent gas supply paths L3 is provided with one or more on-off valves V2 and a second fluid control device MFC2 for controlling the physical quantity of the diluent gas, such as a flow rate or pressure. The second fluid control device MFC2 here is a differential pressure type or thermal type mass flow controller for controlling the flow rate of the diluent gas, as with the above-described first fluid control device MFC1.

One end of the material gas exhaust path L2 is connected to the above-described exhaust port P2, and the other end is connected to, for example, a suction pump P located outside the chamber 10. The material gas exhaust path L2 is provided with pressure regulating means V3 such as a pressure regulating valve and an on-off valve V4.

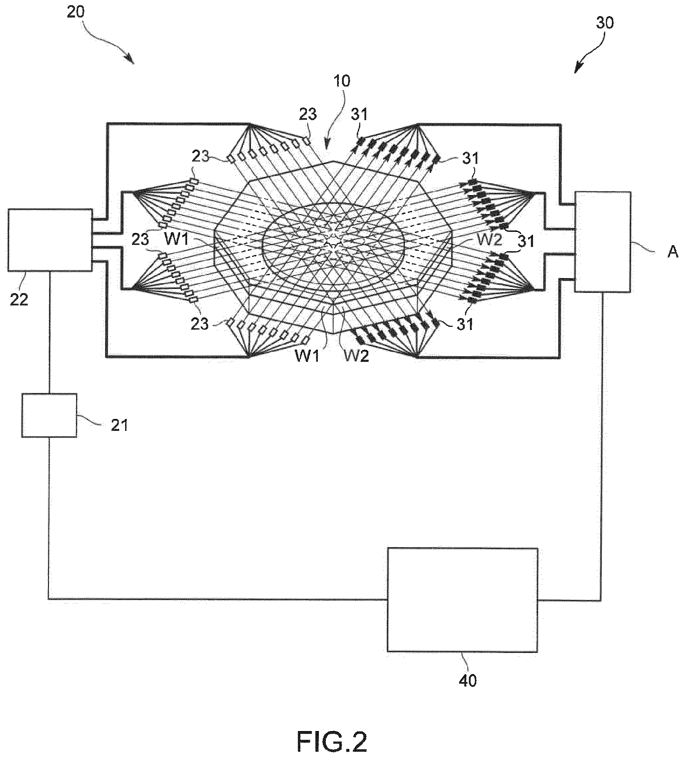

In addition, as illustrated in FIG. 2, the substrate processing apparatus 100 of the present embodiment further includes: a laser emitting mechanism 20 that emits laser beams into the chamber 10 from multiple points around the chamber 10; a laser detecting mechanism 30 that detects respective laser beams having been emitted from the multiple points and passed through the chamber 10; and a control device 40 that acquires beam intensity signals of the respective laser beams detected by the laser detecting mechanism 30 to control the operation of the substrate processing apparatus 100.

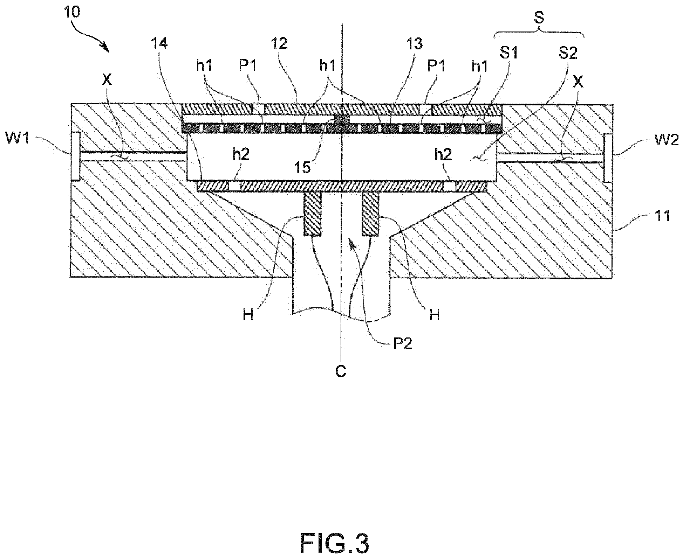

First, to describe the chamber 10 in more detail, as illustrated in FIGS. 3 to 5, the chamber 10 in the present embodiment includes: a chamber main body 11 having the above-described internal space S: an upper side cover member 12 that covers the internal space S from above; a porous member 13 that is provided below the upper side cover member 12 and formed with a number of small holes h1; and a lower side cover member 14 that is provided below the porous member 13 and covers the internal space S from below.

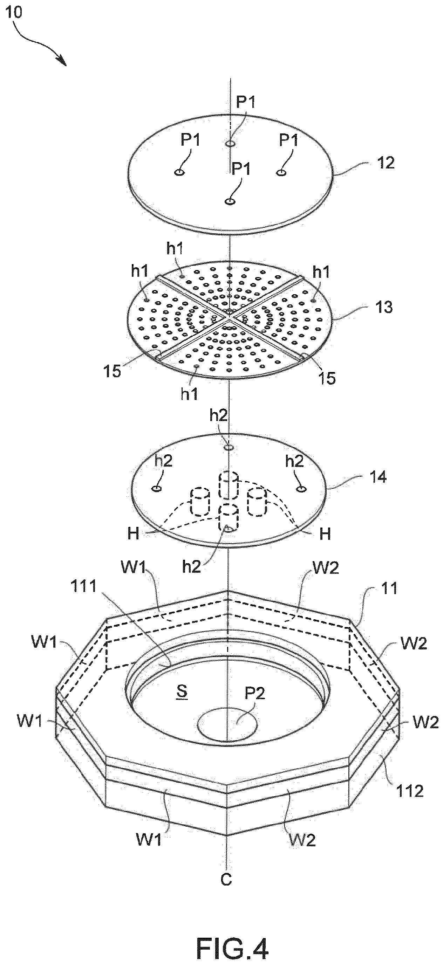

As illustrated in FIG. 4, the chamber main body 11 includes: an inner peripheral surface 111 forming the internal space S of, for example, a rotating body shape; and an outer peripheral surface 112 formed with an incident window W1 and an emission window W2 allowing the laser beams to pass therethrough. Further, the bottom wall of the chamber main body 11 is formed with the above-described one exhaust port P2. In addition, the number and arrangement of exhaust ports P2 may be appropriately changed.

The outer peripheral surface 112 of the chamber main body 11 in the present embodiment is formed in a polygonal shape. In addition, one of a pair of mutually opposite side parts of the outer peripheral surface 112 is formed with the incident window W1, and the other is formed with the emission window W2. The outer peripheral surface 112 here is of an octagonal shape, and one continuous half (four) of the side parts are formed with the incident windows W1, whereas the other continuous half (four) of the side parts are formed with the emission windows W2.

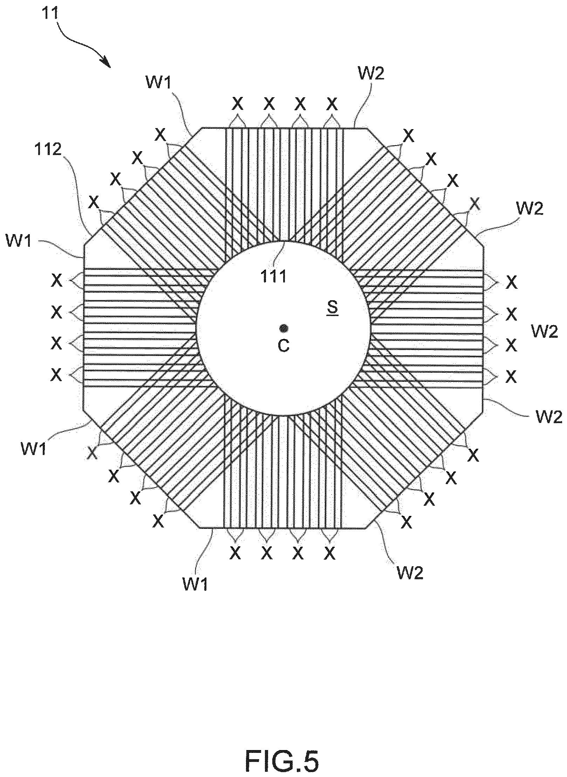

Further, as illustrated in FIG. 5, in the chamber main body 11, laser beam paths X penetrating through the inner and outer peripheral surfaces 111 and 112 are formed. Here, one side part of the outer peripheral surface 112 is formed with multiple laser beam paths X, and the multiple laser beam paths X extend to the opposite side part. That is, a pair of mutually opposite side parts of the outer peripheral surface 112 is formed with multiple laser beam paths X, and here a pair of side parts is formed with 8 laser beam paths X, i.e., 32 laser beam paths X are formed in total. In addition, the number of laser beam paths X for a pair of side parts and the total number of laser beam paths X may be appropriately changed.

These laser beam paths X are all formed in the same plane. Specifically, each of the laser beam paths X is formed along a plane orthogonal to the central axis C of the internal space S, i.e., formed along substrates contained in the internal space S.

As illustrated in FIGS.3 and 4, the upper side cover member 12 forms the upper wall of the chamber 10, and is, for example, a circular plate-like one formed with the above-described multiple supply ports P1. The multiple supply ports P1 are arranged, for example, at regular intervals on a circumference in a top view, and here four supply ports P1 are arranged at regular intervals around the central axis C of the internal space S. In addition, the number and arrangement of supply ports P1 may be appropriately changed.

The porous member 13 is one that as illustrated in FIGS. 3 and 4, is arranged below the upper side cover member 12 with a gap kept. In doing so, the internal space S is partitioned into an upper space S1 above the porous member 13 and a lower space S2 below the porous member 13. The porous member 13 is formed with many small holes h1 penetrating in the thickness direction thereof, and adapted so that the material gas supplied from the supply ports P1 to the upper space S1 spreads over the whole of the lower space S2 while dispersing into these many small holes h1.

As illustrated in FIGS. 3 and 4, the lower side cover member 14 is formed with multiple through-holes h2 for guiding the material gas supplied to the internal space S to the exhaust port P2, and here also used as a substrate holding member on which substrates (not illustrated) are placed. The lower side cover member 14 is, for example, a circular plate-like one formed with the multiple through-holes h2 at positions, for example, corresponding to the above-described supply ports P1. Also, on the lower surface of the lower side cover member, the multiple heaters H such as cartridge heaters are provided.

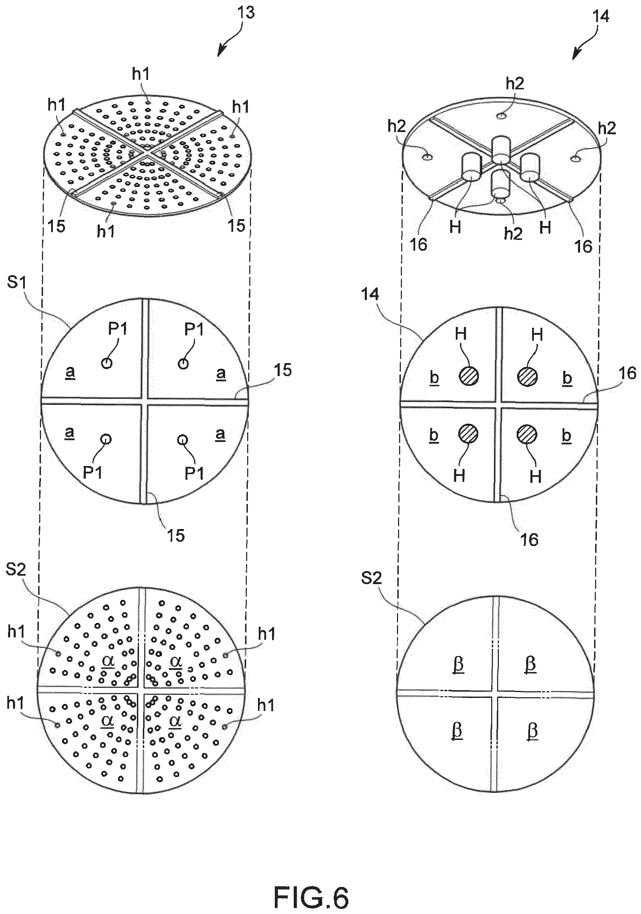

In addition, as illustrated in FIG. 6, the chamber 10 in the present embodiment further includes: partitioning members 15 that are provided below the upper side cover member 12 and partition the multiple supply ports P1; and heat insulating partitioning members 16 that are provided on the lower side cover member 14 and partition the multiple heaters H.

The partitioning members 15 are ones interposed between the upper side cover member 12 and the porous member 13 to spatially partition the multiple supply ports P1, and for example, plate-like ones abutting on the lower surface of the upper side cover member 12 and on the upper surface of the porous member 13. Here, the partitioning members 15 are formed integrally with the upper surface of the porous member 13, but may be provided integrally with the lower surface of the upper side cover member 12 or separate bodies from the porous member 13 and from the upper side cover member 12.

The partitioning members 15 spatially partition the multiple supply ports P1, and thereby the upper space S1 is partitioned into multiple rooms a. The partitioning members 15 here are ones that equally divide the upper space S1 into the rooms a whose number is equal to the number of the supply ports P1 (specifically, into four rooms a), and specifically the paired partitioning members 15 orthogonal to each other and passing through the center of the upper space S1 are provided.

Such a configuration allows the material gas supplied from one supply port P1 to be supplied to only one room a of the upper space S1, and consequently the material gas supplied from each of the supply ports P1 is guided to the lower space S2 without being mixed in the upper space S1.

The partition members 15 allow multiple supply areas α corresponding to the multiple supply ports P1 to be set in the chamber 10. To describe in more detail, the respective supply areas α are areas set in the lower space S2 of the chamber 10, and also areas respectively located below the respective rooms a of the upper space S1 partitioned by the partitioning members 15. In other words, the chamber 10 is configured so that the material gas supplied from one supply port P1 is supplied mainly to one supply area α, and the supply areas α here are ones into which the lower space S2 is equally divided (specifically, equally divided into four) as with the upper space S1.

Meanwhile, the heat insulating partitioning members 16 are ones provided on the lower side cover member 14 to thermally partition the multiple heaters H, and for example, plate-like or sheet-like ones. The heat insulating partitioning members 16 here are provided on the lower surface of the lower side cover member 14, but may be provided on the upper surface of the lower side cover member 14. In addition, the heat insulating partitioning members 16 are not necessarily required to be provided on the lower side cover member 14 as the substrate holding member, and the arrangement of them may be appropriately changed.

The multiple heaters H are thermally partitioned by the heat insulating partitioning members 16, and thereby the lower side cover member 14 is partitioned into multiple sections b. The heat insulating partitioning members 16 here are ones that equally divide the lower side cover member 14 into the sections b whose number is equal to the number of the heaters H (specifically, into four sections b), and specifically, the paired heat insulating partitioning members 16 orthogonal to each other and passing through the center of the lower side cover member 14 are provided. Such a configuration allows one heater H to mainly heat one section b of the lower side cover member 14. In addition, if the number of heaters H is large, a number of heat insulating partitioning members 16 may be provided so as to partition the lower side cover member 14 into sections b, for example, in a grid.

The heat insulating partitioning members 16 allow multiple heating areas β corresponding to the multiple heaters H to be set in the chamber 10. To describe in more detail, the respective heating areas β are areas set in the lower space S2 of the chamber 10, and also areas located above the respective sections b of the lower side cover member 14 partitioned by the heat insulating partitioning members 16. In other words, one heater H is configured to heat mainly one heating area β, and the heating areas β here are areas into which the lower space S2 is equally divided, as with the lower side cover member 14.

Next, the laser emitting mechanism 20, laser detecting mechanism 30, and control device 40 will be described.

As illustrated in FIG. 2, the laser emitting mechanism 20 is one that emits the laser beams from the multiple points around the chamber 10 toward the incident windows W1 formed in the peripheral wall of the chamber 10. Specifically, the laser emitting mechanism 20 includes: a laser beam source 21 such as a semiconductor laser; and a fiber splitter 22 that splits a laser beam emitted from the laser beam source 21 for multiple fibers, and the emission end parts 23 of the respective fibers are arranged to surround the internal space S. Here, the outer peripheral surface 112 of the chamber 10 is of a polygonal shape, and the multiple fibers are provided for each of the multiple (specifically four) side parts of the outer peripheral surface 112. In doing so, the laser beam emitted from the laser beam source 21 is emitted from four directions toward the internal space S.

The laser detecting mechanism 30 is one that as illustrated in FIG. 2, detects the respective laser beams emitted from the multiple points, passing through the chamber 10, and emitted through the emission windows W2 formed in the peripheral wall of the chamber 10. Specifically, the laser detecting mechanism 30 includes multiple laser detectors 31 for detecting the laser beams emitted from the respective fibers and passing through the internal space S, and the respective laser detectors 31 are arranged opposite to the emission end parts 23 of the fibers in such a manner as to interpose the internal space S. The beam intensity signals indicating the intensities of the laser beams detected by these laser detectors 31 are outputted to the above-described control device 40 via an amplifier A and the like.

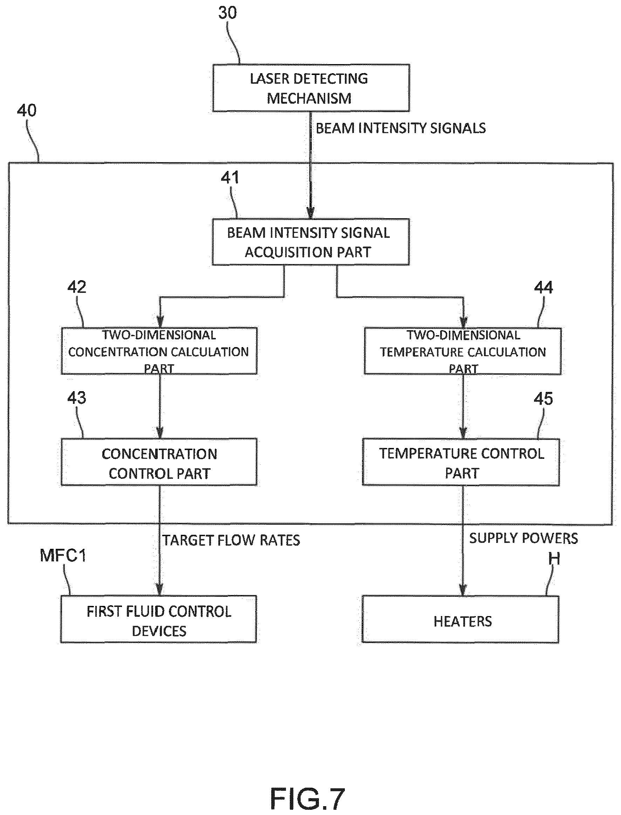

In addition, the control device 40 in the present embodiment is physically a dedicated or general-purpose computer including a CPU, an internal memory, an input/output interface, an AD converter, and the like, and configured to fulfill functions as a beam intensity signal acquisition part 41, a two-dimensional concentration calculation part 42, a concentration control part 43, and the like as illustrated in FIG. 7 by making the CPU and the other components cooperate in accordance with a program for the substrate processing apparatus stored in the internal memory.

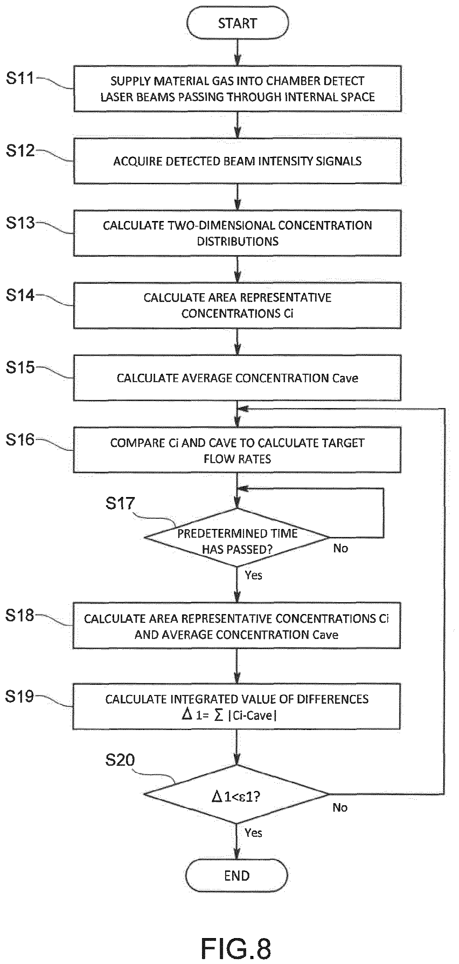

In the following, with reference to a flowchart illustrated in FIG. 8, a concentration control operation of the control device 40 in the present embodiment will be described while describing the respective parts.

First, the laser beams are emitted from the laser emitting mechanism 20 to the internal space S of the chamber 10 in a state where the material gas is supplied from the multiple supply ports P1 to the chamber 10, and the laser beams passing through the internal space S are detected by the laser detecting mechanism 30 (S11). The beam intensity signals detected by the laser detecting mechanism 30 are outputted to the control device 40, and acquired by the beam intensity signal acquisition part 41 (S12).

Then, on the basis of the beam intensity signals acquired by the beam intensity signal acquisition part 41, the two-dimensional concentration calculation part 42 calculates a two-dimensional concentration distribution in the chamber 10 (S13). The two-dimensional concentration distribution here refers to a concentration distribution in a plane along the laser beams in the chamber 10, i.e., a concentration distribution along substrates contained in the chamber 10.

To describe more specifically, the two-dimensional concentration calculation part 42 is configured to calculate a two-dimensional concentration distribution in an area defined by two mutually orthogonal axes by, on the basis of predetermined two-dimensional concentration distribution calculation algorithm, performing a calculation process on beam intensity signals detected by respective laser detectors 31, and calculates two-dimensional concentration distributions at least in the above-described multiple supply areas α.

Subsequently, on the basis of the two-dimensional concentration distributions in the multiple supply areas α calculated by the two-dimensional concentration calculation part 42, the concentration control part 43 controls the above-described first fluid control devices MFC1. The concentration control part 43 uses a two-dimensional concentration distribution in each of the supply areas α to perform feedback control of the target flow rate of a first fluid control device MFC 1 corresponding to the each of the supply areas α. In addition, the first fluid control device MFC1 corresponding to each of the supply areas α refers to a first fluid control device MFC1 provided in a material gas supply path L1 connected to a supply port P1 corresponding to the supply area α (i.e., a supply port P1 from which the material gas is supplied mainly to the supply area α).

To describe more specifically, first, the concentration control part 43 calculates an area representative concentration Ci representing a concentration in each of the supply areas α from a two-dimensional concentration distribution in the supply area α (S14). As the area representative concentration Ci, the average concentration, the maximum concentration, or the like in the two-dimensional concentration distribution in the supply area α can be cited.

Then, the concentration control part 43 calculates the average concentration Cave by averaging the respective area representative concentrations Ci (S15). Subsequently, the concentration control part 43 compares the respective area representative concentrations Ci and the average concentration Cave to calculate the target flow rates of the first fluid control devices MFC1.

Specifically, when an area representative concentration Ci in a supply area α is larger than the average concentration Cave, the target flow rate of a first fluid control device MFC1 corresponding to the supply area α is decreased in order to decrease the area representative concentration Ci. In addition, in this case, the target flow rate of a second fluid control device MFC2 corresponding to the supply area α may be increased.

On the other hand, when an area representative concentration Ci in a supply area α is smaller than the average concentration Cave, the target flow rate of a first fluid control device MFC1 corresponding to the supply area α is increased in order to increase the area representative concentration Ci. In addition, in this case, the target flow rate of a second fluid concentration device MFC2 corresponding to the supply area α may be decreased.

The concentration control part 43 outputs the calculated target flow rates to the first fluid control devices MFC1, and then determines whether or not a predetermined time has passed (S17). Then, after the predetermined time has passed, the concentration control part 43 again calculates area representative concentrations Ci in the respective supply areas α and the average concentration Cave of them (S18), and integrates the differences between the respective area representative concentrations Ci and the average concentration Cave (S19).

Then, the concentration control part 43 compares the resulting integrated value Δ1 and a first threshold value ε1 (S20), and when the integrated value Δ1 is larger than the first threshold value ε1, the flow returns to S16 again, whereas when the integrated value Δ1 is equal to or smaller than the first threshold value ε1, the above-described concentration control is ended.

As illustrated in FIG. 7, the control device 40 in the present embodiment further includes functions as a two-dimensional temperature calculation part 44 and a temperature control part 45.

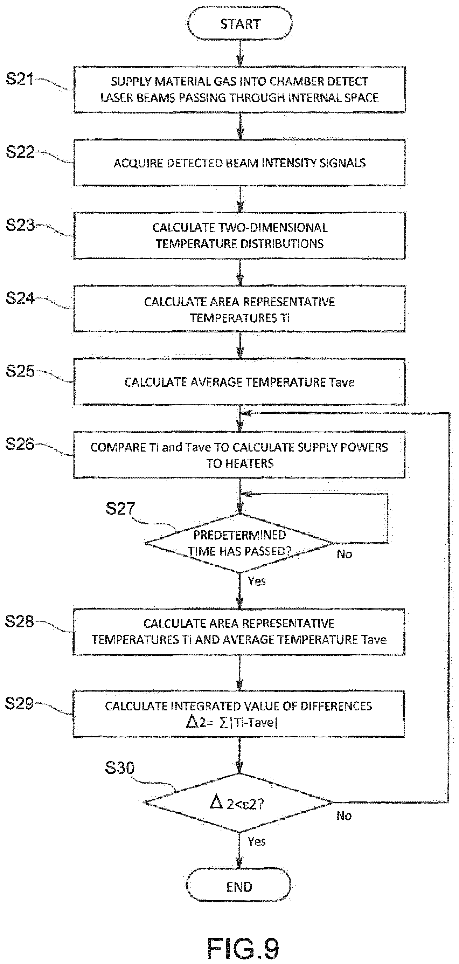

In the following, with reference to a flowchart illustrated in FIG. 9, a temperature control operation of the control device 40 in the present embodiment will be described while describing the respective parts.

First, the laser beams are emitted from the laser emitting mechanism 20 to the internal space S of the chamber 10 in a state where the material gas is supplied to the chamber 10 from the multiple supply ports P1 and the inside of the chamber 10 is heated by the multiple heaters H, and the laser beams passing through the internal space S are detected by the laser detecting mechanism 30 (S21). The beam intensity signals detected by the laser detecting mechanism 30 are outputted to the control device 40, and acquired by the beam intensity signal acquisition part 41 (S22).

Then, on the basis of the beam intensity signals acquired by the beam intensity signal acquisition part 41, the two-dimensional temperature calculation part 44 calculates a two-dimensional temperature distribution in the chamber 10 (S23). The two-dimensional temperature distribution here refers to a temperature distribution in the plane along the laser beams in the chamber 10, i.e., a temperature distribution along substrates contained in the chamber 10.

To describe more specifically, the two-dimensional temperature calculation part 44 is configured to calculate a two-dimensional temperature distribution in an area defined by two mutually orthogonal axes by, on the basis of predetermined two-dimensional temperature distribution calculation algorithm, performing a calculation process on beam intensity signals detected by respective laser detectors 31, and calculates two-dimensional temperature distributions at least in the above-described multiple heating areas β.

Subsequently, on the basis of the two-dimensional temperature distributions in the multiple heating areas β calculated by the two-dimensional temperature calculation part 44, the temperature control part 45 controls the multiple heaters H. The temperature control part 45 is configured to, using a two-dimensional temperature distribution in each of the temperature areas, perform feedback control of a supply power (applied current or applied voltage) to a heater H corresponding to the heating area β. In addition, a heater H corresponding to each of the heating areas β refers to a heater H provided in a section b of the lower side cover member 14 corresponding to the heating area β.

To describe more specifically, first, the temperature control part 45 calculates an area representative temperature Ti representing a temperature in each of the heating areas β from a two-dimensional temperature distribution in the heating area β (S24). As the area representative temperature Ti, the average temperature, the maximum temperature, or the like in the two-dimensional temperature distribution in the heating area β can be cited.

Then, the temperature control part 45 calculates the average temperature Tave by averaging the respective area representative temperatures Ti (S25). Subsequently, the temperature control part 45 compares the respective area representative temperatures Ti and the average temperature Tave to calculate the supply powers to the heaters H (S26).

Specifically, when an area representative temperature Ti in a heating area β is larger than the average temperature Tave, a supply power to a heater H corresponding to the heating area β is decreased in order to decrease the area representative temperature Ti.

On the other hand, when an area representative temperature Ti in a heating area β is smaller than the average temperature Tave, a supply power to a heater H corresponding to the heating area β is increased in order to increase the area representative temperature Ti.

The temperature control part 45 outputs command values indicating the calculated supply powers to a heater control device HC (see FIG. 1), and then determines whether or not a predetermined time has passed (S27). Subsequently, after the predetermined time has passed, the temperature control part 45 again calculates area representative temperatures Ti in the respective heating areas β and the average temperature Tave of them (S28), and integrates the differences between the respective area representative temperatures Ti and the average temperature Tave (S29).

Then, the temperature control part 45 compares the resulting integrated value Δ2 and a predetermined second threshold value ε2 (S30), and when the integrated value Δ2 is larger than the second threshold value ε2, the flow returns to S26 again, whereas when the integrated value Δ2 is equal to or smaller than the second threshold value ε2, the above-described temperature control is ended.

In the substrate processing apparatus 100 configured as described above, since the control device 40 calculates the two-dimensional concentration distribution of the material gas in the chamber 10 on the basis of the beam intensity signals of the respective laser beams emitted from the multiple points around the chamber 10 and passing through the chamber 10, and on the basis of the two-dimensional concentration distribution, controls the first fluid control devices MFC1, the two-dimensional concentration distribution can be uniformed without relying on operator's experience.

Further, since a first fluid control device MFC1 and a second fluid control device MFC2 serving as control targets are made to correspond to each of the multiple supply areas α set in the chamber 10, the two-dimensional concentration distribution in the chamber 10 can be controlled for each of the supply areas α, thus making it possible to uniform the two-dimensional concentration distribution without complicating control.

In addition, since the partitioning members 15 spatially partition the multiple supply ports P1 so that the material gas supplied from one supply port P1 is supplied mainly to one supply area α, the multiple supply areas α can be independently controlled, thus making it possible to more quickly uniform the two-dimensional concentration distribution in the chamber 10.

Also, since the control device 40 calculates the two-dimensional temperature distribution of the material gas in the chamber 10 on the basis of the beam intensity signals of the respective laser beams emitted from the multiple points around the chamber 10 and passing through the chamber 10, and on the basis of the two-dimensional temperature distribution, controls the heaters H, the two-dimensional temperature distribution can be uniformed without relying on operator's experience.

Further, since a heater H serving as a control target is made to correspond to each of the heating areas β set in the chamber 10, the two-dimensional temperature distribution in the chamber 10 can be controlled for each of the heating areas β, thus making it possible to uniform the two-dimensional temperature distribution without complicating control.

In addition, since the heat insulating partitioning members 16 thermally partition the multiple heaters H so that one heater H heats mainly one heating area β, the multiple heating areas β can be independently controlled, thus making it possible to more quickly uniform the two-dimensional temperature distribution in the chamber 10.

Note that the present invention is not limited to the above-described embodiment.

For example, in the above-described embodiment, the control device 40 calculates both of the two-dimensional concentration distribution and the two-dimensional temperature distribution on the basis of the beam intensity signals detected by the respective laser detectors 31, but may calculate any one of the two-dimensional concentration distribution and the two-dimensional temperature distribution. That is, the control device 40 is not necessarily required to calculate both of the two-dimensional concentration distribution and the two-dimensional temperature distribution, and also not necessarily required to include the functions as both of the concentration control part and the temperature control part 45, but may be one that calculates any one of the two-dimensional concentration distribution and the two-dimensional temperature distribution and includes a function as any one of the concentration control part and the temperature control part 45.

In the above-described embodiment, on the basis of the differences between the area representative concentrations Ci and the average concentration Cave, the feedback control of the target flow rates of the first fluid control devices MFC1 is performed, but on the basis of the differences between the area representative concentrations Ci and a predetermined target concentration, feedback control of the target flow rates of the first fluid control devices MFC1 may be performed.

Also, the temperature control may also be performed in the same manner such that, on the basis of the differences between the area representative temperatures Ti and a predetermined target temperature, feedback control of the supply powers to the heaters is performed.

Further, in the above-described embodiment, the outer peripheral surface 112 of the chamber 10 is of a polygonal shape, but the outer peripheral surface 112 of the chamber 10 may be appropriately changed to one of a triangular shape, a rectangular shape, a circular shape, an elliptical shape, or the like.

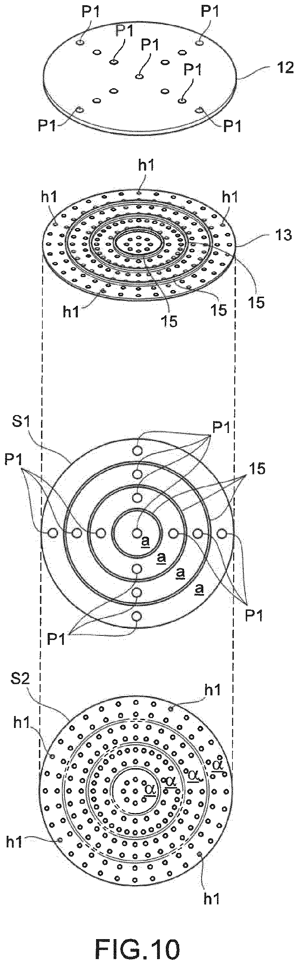

In addition, the partitioning members 15 are not necessarily required to equally divide the upper space S1 as in the above-described embodiment, but for example, as illustrated in FIG. 10, may partition the upper space S1 into concentrically-shaped rooms a. More specifically, the partitioning members 15 partition the upper space S1 in the plane along the laser beams into a circular-shaped room a located in the central part of the upper space S1, and at least one annular room a surrounding the circular-shaped room, and provide multiple annular rooms a. Note that the number of rooms a in this case is smaller than the number of supply ports P1, and each of the rooms a is connected with multiple supply ports P1.

Such partitioning members 15 allow the lower space S2 to have a circular-shaped supply area α set in the central part of the lower space S2 and at least one annular supply area α surrounding the circular-shaped supply area α in the plane along the laser beams, and these supply areas α are areas respectively located below the respective rooms a of the upper space S1 partitioned by the partitioning members 15.

In the above-described configuration, the difference in two-dimensional concentration distribution is likely to occur between the central part and outer peripheral part of the internal space S. However, since the circular-shaped supply area α located in the central part and the multiple annular supply areas α surrounding the supply area α are set, the concentrations in the central part and outer peripheral part of the internal space S can be respectively controlled, thus making it easier to uniform a two-dimensional concentration distribution.

In addition, in the above-described embodiment, described is the case where the laser beam paths X are all formed in the same plane, but as long as the two-dimensional concentration distribution and/or temperature distribution of the material gas in the chamber 10 can be measured enough to be able to produce the working effect of the present invention, all the laser beam paths X are not necessarily required to be formed in the same plane.

Besides, it goes without saying that the present invention is not limited to the above-described embodiment but can be variously modified without departing from the scope thereof.

### Reference Signs List

100: Substrate processing apparatus
10: Chamber
L1: Material gas supply path
L2: Material gas exhaust path
S: Internal space
H: Heater
P1: Supply port
MFC1: First fluid control device
MFC2: Second fluid control device
15: Partitioning member
16: Heat insulating partitioning member
α: Supply area
β: Heating area
20: Laser emitting mechanism
30: Laser detecting mechanism
40: Control device

## Claims

1. A substrate processing apparatus comprising:
a chamber that contains a substrate and is also supplied with material gas;
material gas supply paths respectively connected to multiple supply ports formed in the chamber;
fluid control devices provided in the respective material gas supply paths;
a laser emitting mechanism that emits laser beams from multiple points around the chamber toward an incident window formed in a peripheral wall of the chamber;
a laser detecting mechanism that detects respective laser beams emitted from the multiple points, passing through the chamber, and emitted through an emission window formed in the peripheral wall of the chamber; and
a control device that acquires beam intensity signals of the respective laser beams detected by the laser detecting mechanism, as well as on a basis of the beam intensity signals, calculates a two-dimensional concentration distribution of the material gas in the chamber, and on a basis of the two-dimensional concentration distribution, controls the fluid control devices.

2. The substrate processing apparatus according to claim 1, configured such that multiple supply areas corresponding to the multiple supply ports are set in the chamber, and the material gas supplied to the respective supply areas is controlled by the fluid control devices in the material gas supply paths connected to the supply ports corresponding to the respective supply areas, wherein
the control device calculates, on the basis of the two-dimensional concentration distribution, area representative concentrations representing concentrations in the respective supply areas, and using the area representative concentrations, performs feedback control of target flow rates of the fluid control devices corresponding to the respective supply areas.

3. The substrate processing apparatus according to claim 1 or 2, wherein
the chamber comprises:
a chamber main body having an internal space to which the material gas is supplied;
a cover body that covers the internal space and is also formed with the multiple supply ports; and
a partitioning member that is provided on an internal space side of the cover body and partitions the multiple supply ports.

4. The substrate processing apparatus according to claim 2 or 3, wherein
the multiple supply areas are set as an area set in a central part of the chamber, and at least one annular area surrounding the area.

5. A substrate processing apparatus comprising:
a chamber that contains a substrate and is also supplied with material gas;
multiple heaters for heating an inside of the chamber;
a laser emitting mechanism that emits laser beams from multiple points around the chamber toward an incident window formed in a peripheral wall of the chamber;
a laser detecting mechanism that detects respective laser beams emitted from the multiple points, passing through the chamber, and emitted through an emission window formed in the peripheral wall of the chamber; and
a control device that acquires beam intensity signals of the respective laser beams detected by the laser detecting mechanism, as well as on a basis of the beam intensity signals, calculates a two-dimensional temperature distribution in the chamber, and on a basis of the two-dimensional temperature distribution, controls the heaters.

6. The substrate processing apparatus according to claim 5, wherein
multiple heating areas corresponding to the multiple heaters are set in the chamber, and
the control device calculates, on the basis of the two-dimensional temperature distribution, area representative temperatures representing temperatures in the respective heating areas, and using the area representative temperatures, performs feedback control of supply powers to the respective heaters.

7. The substrate processing apparatus according to claim 5 or 6, comprising
a heat insulating partitioning member that partitions the multiple heaters.

8. A program for a substrate processing apparatus, the program being used for a substrate processing apparatus comprising:
a chamber that contains a substrate and is also supplied with material gas;
material gas supply paths respectively connected to multiple supply ports formed in the chamber;
fluid control devices provided in the respective material gas supply paths;
a laser emitting mechanism that emits laser beams from multiple points around the chamber toward an incident window formed in a peripheral wall of the chamber; and
a laser detecting mechanism that detects respective laser beams emitted from the multiple points, passing through the chamber, and emitted through an emission window formed in the peripheral wall of the chamber;
the program instructing a computer to fulfill a function of acquiring beam intensity signals of the respective laser beams detected by the laser detecting mechanism, as well as on a basis of the beam intensity signals, calculating a two-dimensional concentration distribution of the material gas in the chamber, and on a basis of the two-dimensional concentration distributions, controlling the fluid control devices.

9. A program for a substrate processing apparatus, the program being used for a substrate processing apparatus comprising:
a chamber that contains a substrate and is also supplied with material gas;
multiple heaters for heating an inside of the chamber;
a laser emitting mechanism that emits laser beams from multiple points around the chamber toward an incident window formed in a peripheral wall of the chamber; and
a laser detecting mechanism that detects respective laser beams emitted from the multiple points, passing through the chamber, and emitted through an emission window formed in the peripheral wall of the chamber;
the program instructing a computer to fulfill a function of acquiring beam intensity signals of the respective laser beams detected by the laser detecting mechanism, as well as on a basis of the beam intensity signals, calculating a two-dimensional temperature distribution in the chamber, and on a basis of the two-dimensional temperature distribution, controlling the heaters.
